# EUROPÄISCHE PATENTSCHRIFT

(11) **EP 3 317 963 B1**
(45) Veröffentlichungstag und Bekanntmachung des Hinweises auf die Patenterteilung: **19.02.2020**
(21) Anmeldenummer: 16739432.9
(22) Anmeldetag: 30.06.2016
(51) Int. Cl.: H03F 1/02, H01J 37/32, H03F 3/193, H03F 3/20

(54) **LEISTUNGSVERSORGUNGSSYSTEM UND VERFAHREN ZUR EINSTELLUNG EINER AUSGANGSGRÖSSE DER VERSTÄRKERSTUFE EINES LEISTUNGSVERSORGUNGSSYSTEMS**
POWER SUPPLY SYSTEM, AND METHOD FOR ADJUSTING AN OUTPUT VARIABLE OF THE AMPLIFIER STAGE OF A POWER SUPPLY SYSTEM
SYSTÈME D'ALIMENTATION EN PUISSANCE ET PROCÉDÉ DE RÉGLAGE D'UNE VARIABLE DE SORTIE DE L'ÉTAGE AMPLIFICATEUR D'UN SYSTÈME D'ALIMENTATION EN PUISSANCE

(30) Priorität: 30.06.2015 DE 102015212149
(43) Veröffentlichungstag der Anmeldung: 09.05.2018
(73) Patentinhaber: TRUMPF Hüttinger GmbH + Co. KG, 79111 Freiburg (DE)
(72) Erfinder: GREDE, André, 3018 Bern (CH); GRUNER, Daniel, 79379 Muellheim (DE); BOCK, Christian, 79108 Freiburg (DE); PENA VIDAL, Alberto, 79104 Freiburg (DE); VOR DEM BROCKE, Manuel, 79100 Freiburg (DE)
(74) Vertreter: Trumpf Patentabteilung
(86) Internationale Anmeldenummer: PCT/EP2016/065387
(87) Internationale Veröffentlichungsnummer: WO 2017/001604

(56) Entgegenhaltungen:
- EP-A1- 2 410 655
- US-A- 6 166 598
- US-A1- 2007 145 900
- US-A1- 2008 284 510
- US-A1- 2010 311 365
- US-A1- 2014 213 196
- US-A1- 2014 312 974
- US-B2- 9 041 464

## Beschreibung

Die Erfindung betrifft ein Leistungsversorgungssystem mit einer Verstärkerstufe sowie ein Verfahren zur Einstellung einer Ausgangsgröße der Verstärkerstufe eines Leistungsversorgungssystems.

Vorrichtungen und Verfahren solcher und ähnlicher Art sind z.B. aus den folgenden Schriften bekannt: US8,095,090 B2, US2007/0145900 A1, DE 10 2013 226 511 A1, US2014/0084700 A1, US2009/0004981 A1.

In EP2410655A1 wird ein Verfahren zur Leistungsverstärkung einer Schaltleistungssteuerung mithilfe der Leistungserkennung nach der Leistungsverstärkung offenbart.

In US2010/0311365 A1 wird eine Regelung für einen Leistungsverstärker offenbart, aufweisend eine Amplitudenkorrekturschleife, eine EnergieVersorgung und einen oder mehrere Verstärker.

In US2008/0284510 A1 wird eine Leistungsverstärker-Regelung offenbart, bei der die Spannungsversorgung eines Verstärkers und sein Eingangssignal geregelt wird. Dabei wird dem Spannungsversorgungsregler eine Regeldifferenz oder eine verstärkte Regeldifferenz zugeführt.

Leistungsversorgungssysteme, insbesondere Systeme, die Leistung bei Frequenzen ≥ 1 MHz erzeugen, werden beispielsweise zur Laseranregung, in Plasmabeschichtungsanlagen oder auch für Induktionsanwendungen verwendet. Solche Leistungsversorgungssysteme weisen Verstärker auf, über die die Leistung erzeugt wird, die den Plasmabeschichtungsanlagen, Induktionsanwendungen oder der Laseranregung zugeführt wird. Grundsätzlich gibt es zwei Konzepte, um die Leistungsregelung eines Verstärkers zu implementieren. Bei der Amplitudenregelung wird die Ausgangsleistung des Verstärkers über die Amplitude des Eingangssignals geregelt. Alternativ kann über die Regelung der Versorgungsspannung des Verstärkers die Ausgangsleistung des Verstärkers geregelt werden. Bei dieser Art der Regelung wird die Effizienz über einen großen Dynamikbereich relativ konstant gehalten. Die Verstärker weisen in der Regel zumindest einen Transistor auf, der an die Versorgungsspannung angeschlossen ist. Dadurch, dass die Versorgungsspannung geregelt wird, kann es zu Kombinationen der Ansteuerspannung der Transistoren und der Versorgungsspannung kommen, die den Transistor thermisch beanspruchen. Insbesondere besteht die Gefahr, dass dabei der Transistor beschädigt wird oder seine Lebenszeit erheblich reduziert wird.

Aufgabe der vorliegenden Erfindung ist es, eine Möglichkeit zu schaffen, derartige thermische Beanspruchungen des Transistors zu verhindern, um dadurch Ausfälle und Lebenszeitverkürzungen zu minimieren.

Gelöst wird diese Aufgabe erfindungsgemäß durch ein Leistungsversorgungssystem nach Anspruch 1 mit einer Verstärkerstufe, die zumindest einen mit einem Leistungsanschluss an eine Versorgungsspannung angeschlossenen Transistor, insbesondere LDMOS-Transistor, aufweist, dessen Ansteueranschluss mit einer Ansteuerspannung angesteuert wird, wobei ein erster Regler zur Einstellung der Ansteuerspannung des Transistors und ein zweiter Regler zur Einstellung der Versorgungsspannung vorgesehen sind, wobei der erste Regler eingerichtet ist, dem zweiten Regler ein Zustandssignal zuzuführen, und der zweite Regler eingerichtet ist, das Zustandssignal auszuwerten und darauf zu reagieren, wobei das Zustandssignal sich dadurch auszeichnet, dass es anzeigt, ob der erste Regler, der dieses Zustandssignal generiert, sich im Zustand des Regelungsanschlags befindet.

Dadurch ist es möglich, die Verstärkerstufe in gut kontrollierten Arbeitspunkten oder Bereichen zu betreiben, die die sichere Funktion der Verstärkerstufe sicherstellen. Insbesondere können Situationen vermieden werden, in denen der Transistor der Verstärkerstufe thermisch zu sehr beansprucht wird.

Es kann auch ein Stellwert des ersten Reglers an den Eingang des zweiten Reglers gelegt sein.

Insbesondere ist erfindungsgemäß vorgesehen, die Leistungsregelung auf zwei Kanäle, nämlich den ersten Regler und den zweiten Regler aufzuteilen.

Es kann eine Messeinrichtung zur Erfassung einer Ausgangsgröße der Verstärkerstufe als Regelgröße vorgesehen sein. Mit der Messeinrichtung kann die durch die Verstärkerstufe erzeugte Ausgangsgröße erfasst werden. Diese Ausgangsgröße kann mit einer Sollgröße verglichen werden, um eine Eingangsgröße für einen Regler zu erhalten, insbesondere für den ersten Regler, zu erhalten.

Zu diesem Zweck kann ein Regelabweichungsermittler vorgesehen sein, der aus der Regelgröße und einer Sollgröße eine Regelabweichung ermittelt, wobei der Regelabweichungsermittler mit dem ersten Regler verbunden ist. Auf diese Art und Weise kann eine Regelabweichung ermittelt werden und dem ersten Regler zugeführt werden. Der erste Regler kann somit in einer Regelschleife eine sogenannte closed-loop-Regelung durchführen.

Der Ausgang des ersten Reglers kann mit einem Eingang des zweiten Reglers verbunden sein. Somit kann der zweite Regler anhand der durch den ersten Regler eingestellten Größe eine Stellgröße für die Versorgungsspannung bzw. die Versorgungsspannung selbst einstellen. Die Einstellung der Versorgungsspannung erfolgt demnach in Abhängigkeit der Ausgangsgröße des ersten Reglers.

Der Ausgang des zweiten Reglers kann mit einem Eingang des ersten Reglers verbunden sein. In diesem Fall kann auch der erste Regler seine Ausgangsgröße unter Berücksichtigung der von dem zweiten Regler ermittelten Ausgangsgröße einstellen.

Weiterhin kann der zweite Regler mit dem Regelabweichungsermittler verbunden sein. Es kann also insbesondere vorgesehen sein, dass beiden Reglern die Regelabweichung zugeführt wird und beiden Reglern jeweils das Ausgangssignal des anderen Reglers zugeführt wird. Dadurch erfolgt eine sehr komplexe Regelung. Insbesondere führen beide Regler eine Regelung basierend auf der am Ausgang der Verstärkerstufe gemessenen Ausgangsgröße durch und limitieren gegenseitig ihre Arbeitsbereiche bzw. Einstellungsbereich.

Einer der Regler kann eingerichtet sein, eine Regelung durchzuführen, insbesondere eine closed-loop-Regelung durchzuführen und der andere Regler kann eingerichtet sein, eine Steuerung durchzuführen, also eine open loop-Regelung. Dabei kann insbesondere der erste Regler die closed loop-Regelung durchführen und der zweite Regler die open loop-Regelung durchführen.

Einer der Regler kann eingerichtet sein, dem anderen Regler ein Zustandssignal zuzuführen und der andere Regler kann eingerichtet sein, das Zustandssignal auszuwerten, und insbesondere darauf zu reagieren. Das Zustandssignal kann sich dadurch auszeichnen, dass es anzeigt, dass der Regler, der dieses Zustandssignal generiert, sich im Zustand des Regelungsanschlag (windup) befindet. Der Regler, der eingerichtet ist, das Zustandssignal auszuwerten, kann insbesondere eingerichtet sein, bei Erkennen des Zustands: "der andere Regler befindet sich im Regelungsanschlag" sich umzuschalten von einer closed loop-Regelung zur open loop-Regelung (Steuerbetrieb) oder umgekehrt. Insbesondere kann der erste Regler eingerichtet sein, dem zweiten Regler das Zustandssignal zuzuführen und der zweite Regler kann eingerichtet sein, das Zustandssignal auszuwerten. Der zweite Regler kann eingerichtet sein, dass wenn der erste Regler anzeigt, dass er am Anschlag ist, der zweite Regler als closed-loop-Regler arbeitet und insbesondere die Sollwertabweichung, die auch am Eingang des ersten Reglers anliegt, als Eingangsgröße verwendet. Weiter kann der zweite Regler eingerichtet sein, dass wenn der erste Regler normal regelt, sich also nicht am Anschlag befindet, er als open-loop-Regler (Steuer-Modus) arbeitet, indem er eine vorgegebene Kennlinie abfährt.

In den Rahmen der Erfindung fällt außerdem ein Verfahren zur Einstellung einer Ausgangsgröße der Verstärkerstufe eines Leistungsversorgungssystems nach Anspruch 12, bei dem die Ansteuerspannung eines Transistors der Verstärkerstufe unter Berücksichtigung einer Sollgröße und einer von der Verstärkerstufe erzeugten Ausgangsgröße eingestellt wird und die Versorgungsspannung des Transistors unter Berücksichtigung der Einstellung der Ansteuerspannung eingestellt wird. Der Verstärkerstufe bzw. dem Transistor der Verstärkerstufe werden somit zwei Stellgrößen zugeführt, die es erlauben, den Verstärker bzw. den Transistor mit zwei Freiheitsgraden zu betreiben. Dadurch können unsichere Situationen, insbesondere solche Situationen, die zu einer Überhitzung des Transistors führen, vermieden werden. Insbesondere ist es auf diese Art und Weise möglich, dass nicht alle Arbeitsbereiche beider Stellgrößen (Ansteuerspannung und Versorgungsspannung) frei miteinander kombiniert werden können. Dadurch können Situationen vermieden, in denen der Transistor der Verstärkerstufe zerstört wird, weil bei Betrieb mit geringer Effizienz zu viel Wärme erzeugt wird.

Weiterhin kann vorgesehen sein, dass die Ansteuerspannung unter Berücksichtigung der Einstellung der Versorgungsspannung eingestellt wird. Auch dadurch kann der Bereich eingeschränkt werden, in dem der Transistor, insbesondere ein LDMOS-Transistor, der Verstärkerstufe betrieben wird.

Die Ansteuerspannung kann unter Berücksichtigung einer Sollgröße und/oder einer von der Verstärkerstufe erzeugten Ausgangsgröße eingestellt werden. Durch diese Maßnahme kann noch sicherer sichergestellt werden, dass keine Arbeitspunkte auftreten, die zu einer Zerstörung des Transistors führen.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen und aus den Ansprüchen. Die einzelnen Merkmale können je einzeln für sich oder zu mehreren in beliebiger Kombination bei einer Variante der Erfindung verwirklicht sein.

Ein bevorzugtes Ausführungsbeispiel der Erfindung ist in der Zeichnung schematisch dargestellt und wird nachfolgend mit Bezug zu den Figuren der Zeichnung näher erläutert.

Es zeigen:
- Fig. 1: in stark schematisierter Darstellung ein Plasmasystem mit einem Leistungsversorgungssystem;
- Fig. 2: eine Blockdarstellung zur Darstellung der Regelung von Transistoren einer Verstärkerstufe;
- Fig. 3: ein Diagramm zur Verdeutlichung der Abhängigkeit der Effizienz eines Verstärkers von der Versorgungsspannung.

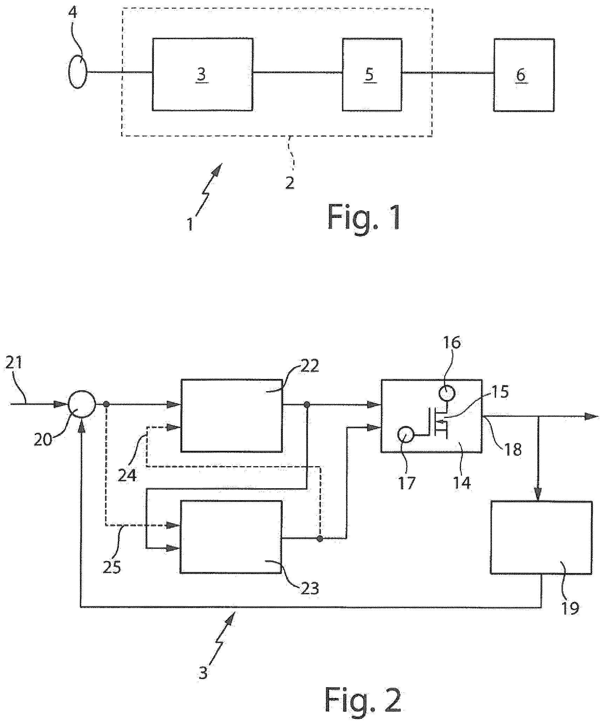

Die Figur 1 zeigt ein Plasmasystem 1, welches ein Leistungsversorgungssystem 2 umfasst. Das Leistungsversorgungssystem 2 weist wiederum einen Leistungswandler 3 auf, der an ein Spannungsversorgungsnetz 4 angeschlossen sein kann. Die am Ausgang des Leistungswandlers 3 erzeugte Leistung wird über ein Impedanzanpassungsnetzwerk 5 an eine Plasmakammer 6 gegeben, wo ein Plasma erzeugt wird, mithilfe dessen eine Plasmabearbeitung in der Plasmakammer 6 durchgeführt werden kann. Insbesondere kann ein Werkstück geätzt werden oder kann eine Materialschicht auf ein Substrat aufgebracht werden.

Die Figur 2 zeigt einen Teil des Leistungsversorgungssystems 3 der Figur 1. Insbesondere umfasst das Leistungsversorgungssystem 3 eine Verstärkerstufe 14, die zumindest einen Transistor 15 aufweist. Der Transistor 15 ist mit einem Leistungsanschluss 16 an eine Versorgungsspannung angeschlossen. Mit einem Ansteueranschluss 17 ist er an eine Ansteuerspannung, beispielsweise eine Gatespannung oder Basisspannung, angeschlossen. Die Verstärkerstufe 14 generiert an ihrem Ausgang 18 ein Ausgangssignal, insbesondere ein Hochfrequenzleistungssignal. An den Ausgang 18 ist eine Messeinrichtung 19 angeschlossen, durch die das Ausgangssignal erfasst werden kann. Das so gemessene Signal wird auf einen Regelabweichungsermittler 20 gegeben, dem ebenfalls eine Sollgröße für die Ausgangsgröße am Ausgang 18 vorgegeben wird. Der Regelabweichungsermittler 20 ermittelt aus der Sollgröße 21 und der Regelgröße, die der Ausgangsgröße der Messeinrichtung 19 entspricht, eine Regelabweichung, die einem ersten Regler 22 zugeführt ist. Der erste Regler 22 ermittelt eine Ansteuerspannung für den Transistor 15 bzw. eine Stellgröße für die Ansteuerspannung des Transistors 15. Der Ausgang des ersten Reglers 22 ist mit einem Eingang des zweiten Reglers 23 verbunden, der anhand der von dem ersten Regler 22 ermittelten Größe eine Versorgungsspannung bzw. eine Stellgröße für die Versorgungsspannung ermittelt und der Verstärkerstufe 14 zuführt.

Optional kann vorgesehen sein, dass auch der Ausgang des zweiten Reglers 23 mit einem Eingang des ersten Reglers 22 verbunden ist. Dies ist durch die gestrichelte Linie 24 angedeutet. Ebenfalls kann dem zweiten Regler 23 die Regelabweichung zugeführt werden, was durch die gestrichelte Linie 25 angedeutet ist. Vorzugsweise arbeitet der Regler 22 in einem geschlossenen Regelkreis und führt demnach eine closed loop control durch, währen der zweite Regler 23 in einer offenen Regelschleife angeordnet ist und somit eine Steuerung oder open loop control durchführt. Allerdings kann nicht nur der Stellwert des ersten Reglers 22 an den Eingang des zweiten Reglers 23 gelegt werden, sondern auch das Zustandssignal, das anzeigt, ob der erste Regler 22 im Anschlag ist. Dieses Zustandssignal wird benutzt, um im zweiten Regler 23 zwischen Steuern (o-pen loop-Regelung) und Regeln (closed-loop-Regelung) umzuschalten. Wenn der erste Regler 22 anzeigt, dass er am Anschlag ist, wird der zweite Regler 23 als Regler (closed-loop-Regelung) verwendet und nimmt die Sollwertabweichung, die auch am Eingang des ersten Reglers 22 anliegt als Eingangsgröße. Wenn der erste Regler 22 normal regelt, folgt der zweite Regler 23 nur im Steuer-Modus (Open-Ioop-Regelung), indem er eine vorgegebene Kennlinie abfährt. Der zweite Regler 23 ist also nicht immer im Steuer-Modus.

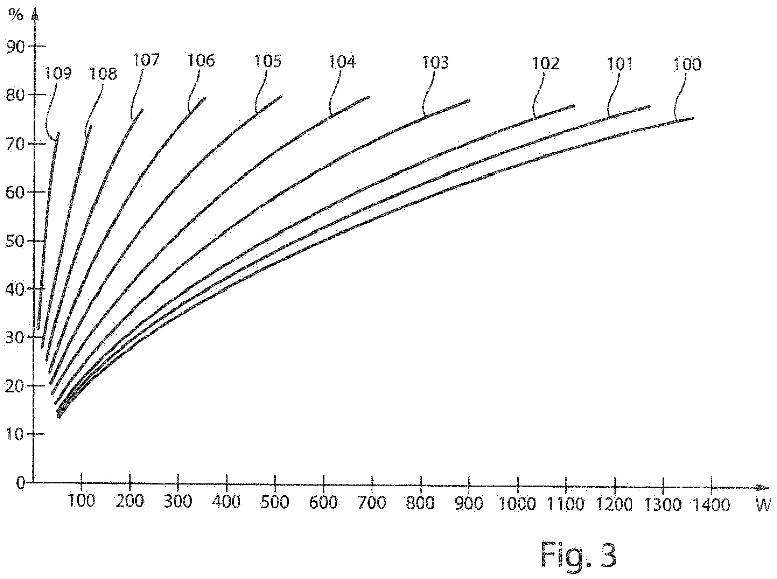

In der Figur 3 ist die Effizienz einer Verstärkerstufe 14 in Abhängigkeit der Ausgangsleistung für unterschiedliche Versorgungsspannungen dargestellt. Dabei wurde die Kurve 100 mit einer Versorgungsspannung von 50 V erzeugt, die Kurve 101 bei einer Versorgungsspannung von 48 V, die Kurve 102 bei einer Versorgungsspannung von 45 V, die Kurve 103 bei einer Versorgungsspannung von 40 V, die Kurve 104 bei einer Versorgungsspannung von 35 V, die Kurve 105 bei einer Versorgungsspannung von 30 V, die Kurve 106 bei einer Versorgungsspannung von 25 V, die Kurve 107 bei einer Versorgungsspannung von 20 V, die Kurve 108 bei einer Versorgungsspannung von 15 V und die Kurve 109 bei einer Versorgungsspannung von 10 V. Besonders deutlich kann man anhand der Figur 100 erkennen, dass bei einer Versorgungsspannung von 50 V eine Ausgangsleistung von etwa 50 W und damit nur eine sehr geringe Effizienz erreicht wird. In einem solchen Fall wird in dem Transistor 15 der Verstärkerstufe 14 sehr viel Leistung in Wärme umgesetzt, was dazu führen kann, dass der Transistor zerstört wird. Solche Zustände gilt es zu vermeiden. Durch die erfindungsgemäße Anordnung gemäß Figur 2 können solche Zustände wirksam vermieden werden.

## Patentansprüche

1. Leistungsversorgungssystem (2) mit einer Verstärkerstufe (14), die zumindest einen mit einem Leistungsanschluss (16) an eine Versorgungsspannung angeschlossenen Transistor (15), insbesondere LDMOS-Transistor, aufweist, dessen Ansteueranschluss (17) mit einer Ansteuerspannung angesteuert wird, wobei ein erster Regler (22) zur Einstellung der Ansteuerspannung des Transistors (15) und ein zweiter Regler (23) zur Einstellung der Versorgungsspannung vorgesehen sind, wobei der erste Regler (22) eingerichtet ist, dem zweiten Regler (23) ein Zustandssignal an den Eingang zuzuführen, und der zweite Regler (23) eingerichtet ist, das Zustandssignal auszuwerten und darauf zu reagieren, **dadurch gekennzeichnet, dass** das Zustandssignal sich dadurch auszeichnet, dass es anzeigt, ob der erste Regler, der dieses Zustandssignal generiert, sich im Zustand des Regelungsanschlags befindet.

2. Leistungsversorgungssystem nach Anspruch 1, **dadurch gekennzeichnet, dass** auch ein Stellwert des ersten Reglers (22) an den Eingang des zweiten Reglers (23) gelegt ist.

3. Leistungsversorgungssystem nach einem der vorhergehenden Ansprüche, **dadurch gekennzeichnet, dass** die Leistungsregelung auf zwei Kanäle, nämlich den ersten Regler (22) und den zweiten Regler (23) aufgeteilt ist.

4. Leistungsversorgungssystem nach einem der vorhergehenden Ansprüche, **dadurch gekennzeichnet, dass** der zweite Regler (23), der eingerichtet ist, das Zustandssignal auszuwerten, eingerichtet ist, bei Erkennen des Zustands "der erste Regler befindet sich im Regelungsanschlag" sich umzuschalten von einer closed loop-Regelung zur open loop-Regelung (Steuerbetrieb) oder umgekehrt.

5. Leistungsversorgungssystem nach Anspruch 4, **dadurch gekennzeichnet, dass** der zweite Regler (23) die Sollwertabweichung, die auch am Eingang des ersten Reglers (22) anliegt, als Eingangsgröße verwendet.

6. Leistungsversorgungssystem nach einem der vorhergehenden Ansprüche, **dadurch gekennzeichnet, dass** ein Regelabweichungsermittler (20) vorgesehen ist, der aus der Regelgröße und einer Sollgröße eine Regelabweichung ermittelt, wobei der Regelabweichungsermittler (20) mit dem ersten Regler (22) verbunden ist.

7. Leistungsversorgungssystem nach einem der vorhergehenden Ansprüche, **dadurch gekennzeichnet, dass** der Ausgang des ersten Reglers (22) mit einem Eingang des zweiten Reglers (23) verbunden ist.

8. Leistungsversorgungssystem nach einem der vorhergehenden Ansprüche, **dadurch gekennzeichnet, dass** der Ausgang des zweiten Reglers (23) mit einem Eingang des ersten Reglers (22) verbunden ist.

9. Leistungsversorgungssystem nach einem der vorhergehenden Ansprüche, **dadurch gekennzeichnet, dass** der zweite Regler (23) mit dem Regelabweichungsermittler (20) verbunden ist

10. Verfahren zur Einstellung einer Ausgangsgröße der Verstärkerstufe (14) eines Leistungsversorgungssystems (2), bei dem die Ansteuerspannung eines Transistors (15) der Verstärkerstufe (14) unter Berücksichtigung einer Sollgröße und einer von der Verstärkerstufe (14) erzeugten Ausgangsgröße mit einem ersten Regler (22) eingestellt wird und die Versorgungsspannung des Transistors (15) unter Berücksichtigung der Einstellung der Ansteuerspannung mit einem zweiten Regler (23) eingestellt wird,wobei der erste Regler 22) dem zweiten Regler (23) ein Zustandssignal an den Eingang zuführt, und der zweite Regler (23) das Zustandssignal auswertet und darauf reagiert, **dadurch gekennzeichnet, dass** das Zustandssignal sich dadurch auszeichnet, dass es anzeigt, ob der erste Regler, der dieses Zustandssignal generiert, sich im Zustand des Regelungsanschlags befindet.

11. Verfahren nach Anspruch 10, **dadurch gekennzeichnet, dass** auch ein Stellwert des ersten Reglers (22) an den Eingang des zweiten Reglers (23) gelegt wird.

12. Verfahren nach einem der vorhergehenden Ansprüche 10 bis 11 **dadurch gekennzeichnet, dass** die Ansteuerspannung unter Berücksichtigung der Einstellung der Versorgungsspannung eingestellt wird.

## Claims

1. Power supply system (2) comprising an amplifier stage (14) which comprises at least one transistor (15), in particular an LDMOS transistor, which is connected to a supply voltage by means of a power terminal (16) and the driving terminal (17) of which is driven by means of a driving voltage, wherein a first controller (22) for adjusting the driving voltage of the transistor (15) and a second controller (23) for adjusting the supply voltage are provided, wherein the first controller (22) is configured to feed a state signal to the input of the second controller (23), and the second controller (23) is configured to evaluate the state signal and to react to the state signal, **characterized in that** the state signal is distinguished **in that** it indicates whether the first controller that generates said state signal is in its control limit state..

2. Power supply system according to claim 1, **characterized in that** also an actuating value of the first controller (22) is applied at the input of the second controller (23.

3. Power supply system according to any one of the preceding claims, **characterized in that** the power control system is divided into two channels, namely the first controller (22) and the second controller (23).

4. Power supply system according to any one of the preceding claims, **characterized in that** the second controller (23) that is configured to evaluate the state signal is configured to switch from closed-loop control to open-loop control (driving mode), or vice versa, when the state of "the first controller is at its control limit" is detected.

5. Power supply system according to claim 4, **characterized in that** the second controller (23) uses the set point deviation as an input variable, which deviation also occurs at the input of the first controller (22).

6. Power supply system according to any one of the preceding claims, **characterized in that** a control deviation determination means (20) is provided which determines a control deviation from the control variable and a set point, the control deviation determination means (20) being connected to the first controller (22).

7. Power supply system according to any one of the preceding claims, **characterized in that** the output of the first controller (22) is connected to an input of the second controller (23).

8. Power supply system according to any one of the preceding claims, **characterized in that** the output of the second controller (23) is connected to an input of the first controller (22).

9. Power supply system according to any one of the preceding claims, **characterized in that** the second controller (23) is connected to the control deviation determination means (20).

10. Method for adjusting an output variable of the amplifier stage (14) of a power supply system (2), in which the driving voltage of a transistor (15) of the amplifier stage (14) is adjusted by a first controller (22) by taking into account a set point and an output variable generated by the amplifier stage (14), and the supply voltage of the transistor (15) is adjusted by a second controller (22) by taking into account the adjustment of the driving voltage, wherein the first controller (22) feeds a state signal to the input of the second controller (23), and the second controller (23) evaluates the state signal and reacts to the state signal, **characterized in that** the state signal is distinguished **in that** it indicates whether the first controller that generates said state signal is in its control limit state..

11. Method according to claim 10, **characterized in that** also an actuating value of the first controller (22) is applied at the input of the second controller (23).

12. Method according to any one of preceding claims 10 to 11, **characterized in that** the driving voltage is adjusted by taking into account the adjustment of the supply voltage.

## Revendications

1. Système d'alimentation en puissance (2) ayant un étage amplificateur (14), qui présente au moins un transistor (15), en particulier un transistor LDMOS, relié par une borne de puissance (16) à une tension d'alimentation, la borne de commande (17) de ce transistor étant commandée par une tension de commande, dans lequel un premier régulateur (22) servant à régler la tension de commande du transistor (15) et un deuxième régulateur (23) servant à régler la tension d'alimentation sont prévus, dans lequel le premier régulateur (22) est conçu pour transmettre au deuxième régulateur (23) un signal d'état à l'entrée et le deuxième régulateur (23) est conçu pour évaluer et répondre au signal d'état, **caractérisé en ce que** le signal d'état est **caractérisé en ce qu'**il indique si le premier régulateur, qui génère ce signal d'état, est dans l'état d'arrêt de régulation.

2. Système d'alimentation en puissance selon la revendication 1, **caractérisé en ce qu'**une valeur de réglage du premier régulateur (22) est également appliquée à l'entrée du deuxième régulateur (23).

3. Système d'alimentation en puissance selon l'une des revendications précédentes, **caractérisé en ce que** la régulation de puissance est divisée en deux canaux, à savoir le premier régulateur (22) et le deuxième régulateur (23).

4. Système d'alimentation en puissance selon l'une des revendications précédentes, **caractérisé en ce que** le deuxième régulateur (23), qui est conçu pour évaluer le signal d'état, est conçu, lors de la reconnaissance de l'état « le premier régulateur est dans l'état d'arrêt de régulation », pour commuter d'une régulation en boucle fermée vers une régulation en boucle ouverte (mode de commande) ou inversement.

5. Système d'alimentation en puissance selon la revendication 4, **caractérisé en ce que** le deuxième régulateur (23) utilise l'écart de consigne, qui est également présent à l'entrée du premier régulateur (22), comme variable d'entrée.

6. Système d'alimentation en puissance selon l'une des revendications précédentes, **caractérisé en ce qu'**un déterminant d'écart de régulation (20) est prévu, lequel détermine un écart de régulation à partir de la variable de régulation et d'une variable de consigne, dans lequel le déterminant d'écart de régulation (20) est connecté au premier régulateur (22).

7. Système d'alimentation en puissance selon l'une des revendications précédentes, **caractérisé en ce que** la sortie du premier régulateur (22) est connectée à une entrée du deuxième régulateur (23).

8. Système d'alimentation en puissance selon l'une des revendications précédentes, **caractérisé en ce que** la sortie du deuxième régulateur (23) est connectée à une entrée du premier régulateur (22).

9. Système d'alimentation en puissance selon l'une des revendications précédentes, **caractérisé en ce que** le deuxième régulateur (23) est connecté au déterminant d'écart de régulation (20).

10. Procédé de réglage d'une variable de sortie de l'étage amplificateur (14) d'un système d'alimentation en puissance (2), dans lequel la tension de commande d'un transistor (15) de l'étage amplificateur (14) est réglée avec un premier régulateur (22) en tenant compte d'une variable de consigne et d'une variable de sortie produite par l'étage amplificateur (14) et la tension d'alimentation du transistor (15) est réglée avec un deuxième régulateur (23) en tenant compte du réglage de la tension de commande, dans lequel le premier régulateur (22) transmet un signal d'état à l'entrée du deuxième régulateur (23) et le deuxième régulateur (23) évalue et répond au signal d'état, **caractérisé en ce que** le signal d'état est **caractérisé en ce qu'**il indique si le premier régulateur, qui génère ce signal d'état, est dans l'état d'arrêt de régulation.

11. Procédé selon la revendication 10, **caractérisé en ce qu'**une valeur de réglage du premier régulateur (22) est également appliquée à l'entrée du deuxième régulateur (23).

12. Procédé selon l'une des revendications précédentes 10 à 11 précédentes, **caractérisé en ce que** la tension de commande est réglée en tenant compte du réglage de la tension d'alimentation.
